# FASCICULE DE BREVET EUROPEEN

(11) **EP 3 916 788 B1**
(45) Date de publication et mention de la délivrance du brevet: **28.09.2022**
(21) Numéro de dépôt: 21174887.6
(22) Date de dépôt: 20.05.2021
(51) Int. Cl.: H01L 27/15, H01L 25/16, H01L 33/00, H01L 33/38, H01L 33/62, H01L 27/146

(54) **PROCÉDÉ DE FABRICATION D'UN DISPOSITIF OPTOÉLECTRONIQUE COMPORTANT UNE PLURALITÉ DE DIODES**
HERSTELLUNGSVERFAHREN EINER OPTOELEKTRONISCHEN VORRICHTUNG, DIE EINE VIELZAHL VON DIODEN UMFASST
METHOD FOR MANUFACTURING AN OPTOELECTRONIC DEVICE COMPRISING A PLURALITY OF DIODES

(30) Priorité: 29.05.2020 FR 2005712
(43) Date de publication de la demande: 01.12.2021
(73) Titulaire: Commissariat à l'Energie Atomique et aux Energies Alternatives, 75015 Paris (FR)
(72) Inventeur: BATUDE, Perrine, 38054 GRENOBLE CEDEX 09 (FR); BONO, Hubert, 38054 GRENOBLE CEDEX 09 (FR)
(74) Mandataire: Cabinet Beaumont

(56) Documents cités:
- EP-A1- 3 401 958
- WO-A1-2017/194845
- FR-A1- 3 073 669

## Description

### Domaine technique

La présente description concerne le domaine des dispositifs optoélectroniques. Elle concerne plus particulièrement un procédé de fabrication d'un dispositif optoélectronique comportant une pluralité de diodes semiconductrices, par exemple au nitrure de gallium, et un circuit électronique de contrôle de ces diodes.

### Technique antérieure

On a déjà proposé un dispositif d'affichage émissif comportant une matrice de diodes électroluminescentes (LED) au nitrure de gallium (GaN), et un circuit de contrôle permettant de commander individuellement les LED pour afficher des images.

Pour réaliser un tel dispositif, on peut prévoir de fabriquer séparément le circuit de contrôle et la matrice de LED, puis de les hybrider, c'est-à-dire de les empiler en les connectant l'un à l'autre.

Un inconvénient de cette méthode de fabrication réside dans la nécessité d'aligner précisément le circuit de contrôle et la matrice de LED lors de l'étape d'assemblage de ces deux éléments, de façon que chaque LED vienne bien se positionner sur un plot métallique qui lui correspond dans le circuit de contrôle. Cet alignement est notamment difficile à réaliser lorsque le pas des pixels diminue, et constitue un frein à l'augmentation de la résolution et/ou de la densité d'intégration des pixels.

Pour pallier cet inconvénient, il a été proposé, dans la demande de brevet internationale WO2017194845 déposée par le demandeur le 13 mai 2016, ainsi que dans la demande de brevet français FR3073669 déposée par le demandeur le 10 novembre 2017, de :
- réaliser d'abord le circuit de contrôle sous la forme d'un circuit intégré comportant, sur une face, une pluralité de plots métalliques destinés à être connectés aux LED de façon à permettre de contrôler individuellement le courant circulant dans chaque LED ;
- rapporter ensuite sur la face du circuit de contrôle comportant les plots métalliques un empilement actif de LED s'étendant de façon continue sur toute la surface du circuit de contrôle ; puis
- structurer l'empilement actif de LED à partir de sa face opposée au circuit de contrôle, de façon à délimiter et isoler les unes des autres les différentes LED du dispositif.

Un avantage de ce procédé de fabrication est que, lors de l'étape de report de l'empilement actif de LED sur le circuit de contrôle, les positions des différentes LED du dispositif dans l'empilement actif ne sont pas encore définies. Il n'y a par conséquent pas de contrainte forte en termes de précision d'alignement lors du report. La délimitation des différentes LED dans l'empilement actif peut ensuite être réalisée par des procédés de structuration d'un substrat et de dépôt de couches isolantes et conductrices sur un substrat, qui offrent une précision d'alignement nettement supérieure à la précision qui peut être obtenue lors d'un report d'un substrat sur un autre.

Il a par ailleurs été proposé, dans la demande de brevet français FR3065322 déposée par le demandeur le 18 avril 2017, de :
- réaliser une matrice de LED comportant chacune des électrodes accessibles depuis une face arrière de la matrice ;
- rapporter, sur la face arrière de la matrice de LED, un empilement de couches comprenant au moins une couche de semiconducteur, une couche de diélectrique de grille et une couche de matériau conducteur de grille ; puis
- réaliser à partir de l'empilement de couches, un circuit de contrôle couplé aux électrodes des LED.

Là encore, un avantage de ce procédé de fabrication est que, lors de l'étape de report de l'empilement de couches sur la matrice de LED, les positions des composants du circuit de contrôle et des métallisations de connexion du circuit de contrôle à la matrice de LED ne sont pas encore définies. Il n'y a par conséquent pas de contrainte forte en termes de précision d'alignement lors du report. La formation des composants du circuit de contrôle et des métallisations de connexion du circuit de contrôle à la matrice de LED peut ensuite être réalisée par des procédés de fabrication de circuits intégrés, qui offrent une précision d'alignement nettement supérieure à la précision qui peut être obtenue lors d'un report d'un substrat sur un autre.

Il a de plus été récemment proposé, dans la demande de brevet français FR1873315 déposée par le demandeur le 19 décembre 2018, de :
- réaliser un empilement actif de LED s'étendant de façon continue sur toute la surface du dispositif d'affichage ;
- rapporter une couche semiconductrice sur la face supérieure de l'empilement actif de LED, puis former, dans et sur la couche semiconductrice une pluralité de transistors MOS ; et
- former des tranchées s'étendant verticalement à travers la couche semiconductrice et au moins une partie de l'épaisseur de l'empilement actif de LED, les tranchées délimitant une pluralité de pixels comprenant chacun une LED et au moins un transistor MOS de contrôle de la LED.

Là encore, il n'y a pas de contrainte forte en termes de précision d'alignement lors du report. La formation des transistors MOS de contrôle et des tranchées de délimitation des pixels peut ensuite être réalisée par des procédés de fabrication de circuits intégrés, qui offrent une précision d'alignement élevée.

Il serait souhaitable d'améliorer au moins en partie certains aspects des procédés de fabrication de dispositifs optoélectroniques décrits dans les demandes de brevet susmentionnées.

EP 3 401 958 Al divulgue un procédé de fabrication d'un dispositif optoélectronique selon l'art antérieur.

### Résumé de l'invention

Un mode de réalisation prévoit un procédé de fabrication d'un dispositif optoélectronique, comportant les étapes suivantes :
a) former un empilement actif de diode comportant une première couche semiconductrice dopée d'un premier type de conductivité et une deuxième couche semiconductrice dopée du deuxième type de conductivité, revêtant la face supérieure de la première couche ;
b) former un circuit intégré de contrôle comprenant une pluralité de cellules élémentaires de contrôle comprenant chacune au moins un transistor MOS ;
c) après les étapes a) et b), rapporter le circuit intégré de contrôle sur la face supérieure de l'empilement actif de diode ; et
d) après l'étape c), former, depuis la face du circuit intégré de contrôle opposée à l'empilement actif de diode, des tranchées s'étendant verticalement à travers le circuit intégré de contrôle et débouchant dans la première couche ou sur la face supérieure de la première couche et délimitant une pluralité de pixels comprenant chacun une diode et une cellule élémentaire de contrôle.

Selon un mode de réalisation, en vue de dessus, les tranchées forment une grille continue séparant les uns des autres les pixels du dispositif.

Selon un mode de réalisation, le procédé comprend une étape de remplissage des tranchées par du métal de façon à former une métallisation de contact avec la première couche semiconductrice, commune à tous les pixels du dispositif.

Selon un mode de réalisation, avant le remplissage des tranchées par du métal, une couche d'isolation est déposée sur les parois latérales des tranchées.

Selon un mode de réalisation, à l'étape b), la troisième couche semiconductrice est retirée dans les zones de formation des tranchées.

Selon un mode de réalisation, la troisième couche semiconductrice n'est pas retirée dans les zones de formation des tranchées avant l'étape d).

Selon un mode de réalisation, le procédé comprend en outre, après l'étape c), une étape de formation, dans chaque pixel, d'une métallisation de contact avec la deuxième couche semiconductrice, et d'une métallisation de contact avec la troisième couche semiconductrice.

Selon un mode de réalisation, la métallisation de contact avec la deuxième couche semiconductrice et la métallisation de contact avec la troisième couche semiconductrice sont des métallisations distinctes, connectées l'une à l'autre par une piste conductrice en contact avec les faces supérieures desdites métallisations.

Selon un mode de réalisation, la métallisation de contact avec la deuxième couche semiconductrice et la métallisation de contact avec la troisième couche conductrice sont confondues et sont disposées dans une même ouverture traversant la troisième couche semiconductrice.

Selon un mode de réalisation, le procédé comprend en outre, avant l'étape c), une étape de dépôt d'une couche métallique sur et en contact avec la face de la deuxième couche semiconductrice opposée à la première couche semiconductrice.

Selon un mode de réalisation, le procédé comprend en outre, avant l'étape c), la formation d'un plan de masse conducteur ou semiconducteur entre la deuxième couche semiconductrice et la troisième couche semiconductrice, le plan de masse étant isolé des deuxième et troisième couches semiconductrices.

Selon un mode de réalisation, le procédé comprend une étape de formation, dans chaque pixel, d'une métallisation de contact avec le plan de masse, ladite métallisation étant disposée dans une ouverture traversant la troisième couche semiconductrice.

Selon un mode de réalisation, à l'étape c), le circuit intégré de contrôle est rapporté de façon que les grilles des transistors MOS soient orientées à l'opposé de la face supérieure de l'empilement actif de diode.

Selon un mode de réalisation, à l'étape c), le circuit intégré de contrôle est rapporté de façon que les grilles des transistors MOS soient orientées vers l'empilement actif de diode.

Selon un mode de réalisation, les première et deuxième couches semiconductrices sont des couches à base de matériaux semiconducteurs III-V, et la troisième couche semiconductrice est en silicium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre une étape d'un procédé de fabrication d'un dispositif optoélectronique selon un mode de réalisation ;
la figure 2 illustre une autre étape d'un procédé de fabrication d'un dispositif optoélectronique selon un mode de réalisation ;
la figure 3 illustre une autre étape d'un procédé de fabrication d'un dispositif optoélectronique selon un mode de réalisation ;
la figure 4 illustre une autre étape d'un procédé de fabrication d'un dispositif optoélectronique selon un mode de réalisation ;
la figure 5 illustre une autre étape d'un procédé de fabrication d'un dispositif optoélectronique selon un mode de réalisation ;
la figure 6 illustre une autre étape d'un procédé de fabrication d'un dispositif optoélectronique selon un mode de réalisation ;
la figure 7 illustre une autre étape d'un procédé de fabrication d'un dispositif optoélectronique selon un mode de réalisation ;
la figure 8 illustre une autre étape d'un procédé de fabrication d'un dispositif optoélectronique selon un mode de réalisation ;
la figure 9 illustre une première variante du procédé des figures 1 à 8 ;
la figure 10 illustre une deuxième variante du procédé des figures 1 à 8 ;
la figure 11 illustre une troisième variante du procédé des figures 1 à 8 ; et
la figure 12 illustre une quatrième variante du procédé des figures 1 à 8.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation complète du circuit de contrôle des dispositifs décrits n'a pas été détaillée, la réalisation d'un tel circuit étant à la portée de l'homme du métier à partir des indications de la présente description. De plus, la composition et l'agencement des différentes couches d'un empilement actif de diode semiconductrice n'ont pas été détaillés, les modes de réalisation décrits étant compatibles avec les empilements actifs usuels de diodes semiconductrices, notamment au nitrure de gallium.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

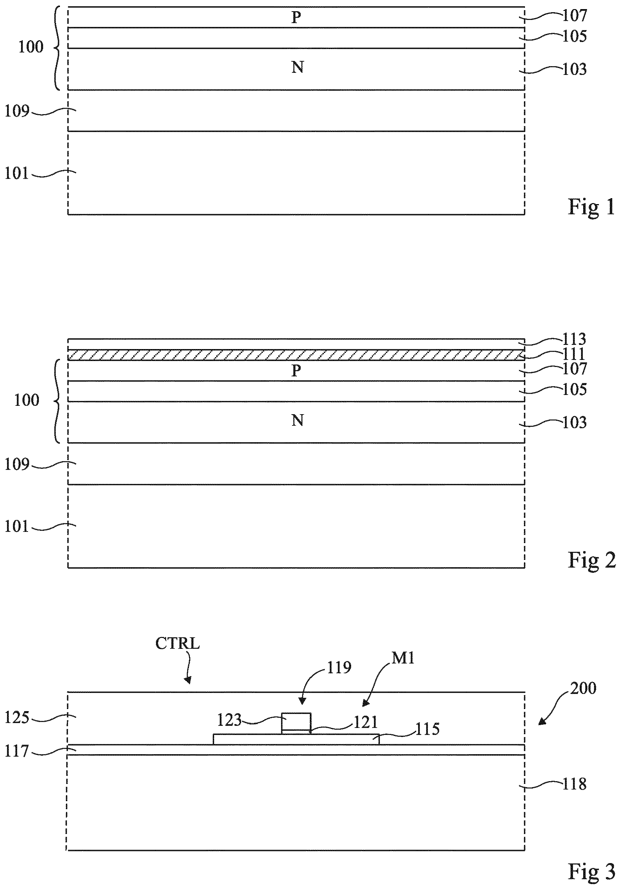

Les figures 1 à 8 sont des vues en coupe illustrant de façon schématique et partielle des étapes successives d'un exemple d'un procédé de fabrication d'un dispositif optoélectronique selon un mode de réalisation. On notera que sur les figures 1 à 8, seul un pixel du dispositif est entièrement représenté, étant entendu que, en pratique, un grand nombre de pixels sont formés simultanément sur un même substrat de support.

La figure 1 représente une structure de départ comportant un empilement actif de LED 100 disposé sur la face supérieure d'un substrat de support 101. Le substrat 101 est par exemple en silicium, en saphir, en corindon, ou en tout autre matériau sur lequel un empilement actif de LED peut être déposé. Dans l'exemple représenté, l'empilement actif 100 comprend, dans l'ordre en partant de la face supérieure du substrat 101, une couche semiconductrice dopée de type N 103, une couche émissive 105, et une couche semiconductrice dopée de type P 107. Les couches semiconductrices 103 et 107 sont par exemple en nitrure de gallium (GaN). La couche émissive 105 est par exemple constituée par un empilement de puits quantiques, par exemple à base de nitrure de gallium et/ou de nitrure d'indium-gallium (InGaN). Dans cet exemple, la face inférieure de la couche émissive 105 est en contact avec la face supérieure de la couche 103, et la face supérieure de la couche émissive 105 est en contact avec la face inférieure de la couche 107. En pratique, selon la nature du substrat 101, un empilement 109 d'une ou plusieurs couches tampon, par exemple à base de nitrure d'aluminium (AlN), de nitrure d'aluminium-gallium (AlGaN) et/ou de nitrure de gallium, peut faire interface entre le substrat de support 101 et la couche 103. L'empilement actif 100 est par exemple formé par épitaxie à partir de la face supérieure du substrat 101. A ce stade, chacune des couches 103, 105 et 107 de l'empilement actif 100 s'étend de façon continue et présente une épaisseur sensiblement uniforme sur sensiblement toute la surface du substrat 101. A titre d'exemple, l'épaisseur de la couche semiconductrice 103 est comprise entre 100 nm et 3 µm, par exemple de l'ordre de 700 nm. L'épaisseur de la couche émissive 105 peut être comprise entre 10 et 200 nm, par exemple de l'ordre de 100 nm. L'épaisseur de la couche semiconductrice 107 est par exemple comprise entre 50 et 300 nm, par exemple de l'ordre de 100 nm.

La figure 2 illustre une étape de dépôt d'une couche conductrice de contact 111, par exemple une couche métallique, sur et en contact avec la face supérieure de la couche semiconductrice 107. La couche 111 est par exemple en aluminium. L'épaisseur de la couche 111 est par exemple comprise entre 5 et 200 nm, par exemple de l'ordre de 100 nm.

La figure 2 illustre en outre une étape de dépôt d'une couche diélectrique de collage 113 sur la face supérieure de la couche conductrice 111, par exemple en contact avec la face supérieure de la couche conductrice 111. La couche 113 est par exemple en oxyde de silicium.

A ce stade, chacune des couches 111 et 113 s'étend de façon continue et présente une épaisseur sensiblement uniforme sur sensiblement toute la surface supérieure du substrat 101.

La figure 3 illustre une étape parallèle de formation d'un circuit intégré de contrôle 200 comprenant, pour chaque pixel du dispositif, une cellule élémentaire de contrôle CTRL destinée à être connectée à la LED du pixel pour permettre de contrôler individuellement le courant circulant dans la LED du pixel et donc l'intensité lumineuse émise par la LED du pixel. Chaque cellule élémentaire de contrôle CTRL comprend notamment au moins un transistor MOS M1 destiné à être connecté à une électrode de la LED du pixel. Le schéma électrique des cellules élémentaires de contrôle CTRL n'a pas été représenté et ne sera pas détaillé ici, les modes de réalisation décrits étant compatibles avec tous les schémas électriques connus de cellules élémentaires de contrôle d'un dispositif d'affichage émissif à LED.

L'étape de la figure 3 peut être mise en oeuvre avant, pendant ou après les étapes des figures 1 et 2.

Lors de l'étape de la figure 3, les transistors M1 du circuit de contrôle 200 sont formés dans et sur une couche semiconductrice 115, par exemple en silicium. Dans l'exemple représenté, la couche 115 repose sur et en contact avec la face supérieure d'une couche diélectrique 117, par exemple en oxyde de silicium. La couche diélectrique 117 repose quant à elle sur et en contact avec la face supérieure d'un substrat de support 118, par exemple en silicium. L'ensemble comprenant le substrat 118, la couche diélectrique 117 et la couche semiconductrice supérieure 115 forme une structure de type SOI (semiconducteur sur isolant).

A titre d'exemple, les couches 118, 117 et 115 s'étendent initialement de façon continue sur toute la surface du circuit de contrôle 200.

Le procédé de fabrication du circuit de contrôle 200 illustré par la figure 3 peut comprendre une étape de retrait localisé de la couche semiconductrice 115, par exemple par photolithographie et gravure s'interrompant sur la face supérieure de la couche diélectrique 117. Cette étape permet de délimiter dans la couche 115, dans chaque pixel du dispositif d'affichage, un ou plusieurs caissons semiconducteurs destinés à contenir chacun un ou plusieurs transistors MOS de la cellule élémentaire de contrôle du pixel.

Le procédé illustré par la figure 3 peut en outre comprendre une étape de formation des grilles des transistors MOS du circuit de contrôle. Pour cela, un empilement de grille 119 est formé au-dessus de la région de canal de chacun des transistors MOS du circuit de contrôle. L'empilement de grille 119 comprend une couche d'isolant de grille 121, par exemple en oxyde de silicium, disposée sur et en contact avec la face supérieure de la couche semiconductrice 115, et une couche conductrice 123, par exemple en silicium polycristallin dopé ou en métal, disposée sur et en contact avec la face supérieure de la couche diélectrique 121. L'empilement de grille 119 est par exemple dans un premier temps déposé de façon continue sur toute la surface du substrat 101, puis retiré de façon localisée, par exemple par photolithographie et gravure, en regard des régions de source et de drain des transistors.

On notera que l'ordre des étapes susmentionnées de gravure localisée de la couche semiconductrice 115 et de formation des grilles des transistors peut être inversé. De plus, la réalisation des transistors du circuit de contrôle du dispositif d'affichage peut comprendre de nombreuses autres étapes, non détaillées ici, par exemple d'implantation des régions de source, de drain et/ou de canal des transistors, de réalisation d'espaceurs, de siliciuration de la face supérieure des régions de contact de source, de drain et/ou de grille des transistors, etc.

La figure 3 illustre en outre une étape postérieure à la fabrication des transistors MOS du circuit de contrôle, dans laquelle une couche 125 d'un matériau diélectrique est déposée sur la face supérieure de l'assemblage. La couche 125, aussi appelée couche diélectrique pré-métal, s'étend par exemple de façon continue sur sensiblement toute la surface du dispositif. L'épaisseur de la couche 125 est de préférence supérieure à la somme des épaisseurs de la couche semiconductrice 115 et de l'empilement de grille 119. A titre d'exemple, l'épaisseur de la couche 125 est comprise entre 100 nm et 700 nm.

On peut dès à présent noter que par rapport aux procédés décrits dans les demandes de brevet FR3065322 et FR1873315 susmentionnés, un avantage du procédé des figures 1 à 8 est que le budget thermique pour la réalisation des transistors MOS du circuit 200 n'est pas limité par la présence de l'empilement actif de LED. En effet, à la différence des procédés décrits dans les demandes de brevet FR3065322 et FR1873315 susmentionnés dans lesquels les transistors MOS du circuit de contrôle sont réalisés dans et sur une couche semiconductrice préalablement reportée sur l'empilement actif de LED, dans le procédé des figures 1 à 8, les transistors MOS du circuit 200 sont réalisés séparément de l'empilement actif de LED.

Après les étapes des figures 1, 2 et 3, le circuit 200 est reporté sur la face supérieure de l'empilement actif de LED 100.

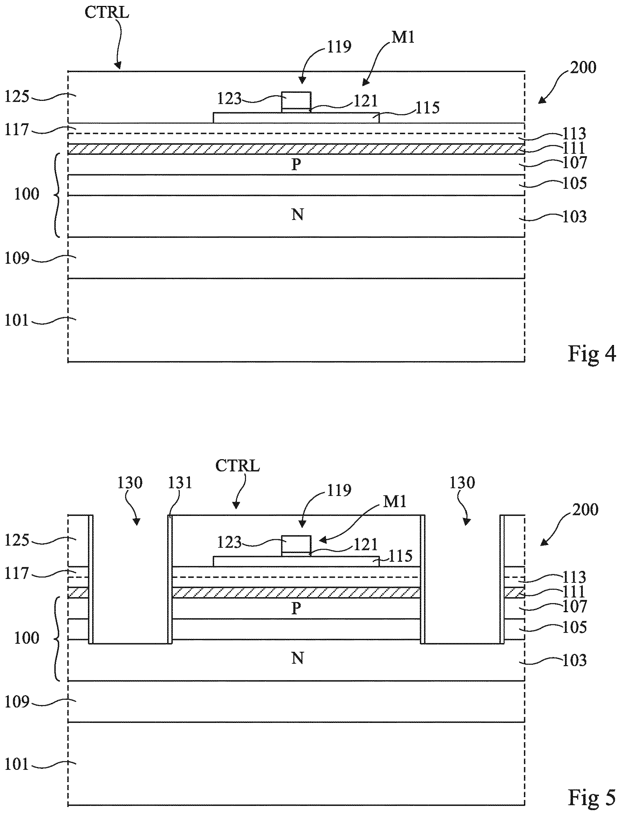

La figure 4 illustre la structure obtenue à l'issue de cette étape de report.

Dans cet exemple, le circuit 200 est d'abord fixé, par sa face supérieure (côté couche diélectrique 125), sur une poignée de support temporaire (non représentée), puis aminci par sa face inférieure de façon à retirer entièrement le substrat 118. L'ensemble comportant la poignée de support et le circuit 200 est ensuite rapporté sur la face supérieure de la couche diélectrique 113, de façon à mettre en contact la face inférieure de la couche diélectrique 117 avec la face supérieure de la couche diélectrique 113. On réalise ainsi un collage direct ou collage moléculaire de la couche 117 sur la couche 113, permettant de solidariser le circuit 200 à la couche 113. La poignée de support temporaire est ensuite retirée de façon à libérer l'accès à la face supérieure du circuit de contrôle 200.

On notera que les modes de réalisation décrits ne se limitent pas au cas particulier décrit ci-dessus dans lequel le circuit de contrôle 200 est formé dans et sur une structure de type SOI. A titre de variante, le circuit 200 peut être formé dans et sur un substrat semiconducteur massif. Après l'étape d'amincissement du substrat par sa face inférieure (i.e. opposée aux transistors MOS), une couche diélectrique peut alors être déposée sur la face inférieure du substrat, pour permettre un collage direct diélectrique-diélectrique du circuit de contrôle 200 sur la couche 113. A titre de variante, un niveau de contact peut être réalisé avant le report.

La figure 5 illustre une étape de gravure de tranchées 130 s'étendant verticalement depuis la face supérieure de la couche diélectrique 125 en direction de la face inférieure du substrat. A cette étape, la gravure des tranchées 130 est interrompue dans la couche semiconductrice inférieure 103 de l'empilement actif de LED 100 ou sur la face supérieure de la couche semiconductrice inférieure 103. Les tranchées 130 délimitent des îlots ou mésas correspondant chacun à un pixel du dispositif, étant entendu que chaque pixel comporte une LED commandable individuellement (i.e. indépendamment des autres LED du dispositif) et une cellule élémentaire de contrôle CTRL de la LED. Ainsi, les tranchées 130 délimitent, dans l'empilement actif de LED 100, une pluralité de LED commandables individuellement, et, dans le circuit 200, une pluralité de cellules élémentaires de contrôle CTRL correspondantes, chaque cellule élémentaire de contrôle CTRL étant destinée à commander la LED sous-jacente. En vue de dessus, les pixels du dispositif peuvent être agencés en matrice, les tranchées 130 formant une grille continue telle que chaque pixel soit entièrement entouré de tranchées 130, et telle que deux pixels voisins soient séparés l'un de l'autre par une tranchée 130. L'alignement des tranchées 130 peut par exemple être réalisé par rapport à des marques d'alignement préalablement réalisées sur le circuit de contrôle 200.

On notera que dans cet exemple, la couche semiconductrice 115 a préalablement été retirée, lors de l'étape de la figure 3, dans les zones de formation des tranchées 130. La gravure des tranchées 130 ne traverse donc pas la couche semiconductrice 115. Les modes de réalisation décrits ne se limitent toutefois pas à ce cas particulier.

La figure 5 illustre en outre une étape de formation d'espaceurs isolants 131, par exemple en oxyde de silicium ou en nitrure de silicium, sur les parois latérales des tranchées 130. A titre d'exemple, pour former les espaceurs 131, une couche d'un matériau isolant est d'abord déposée de façon continue sur toute la surface supérieure de l'assemblage, par exemple par une méthode de dépôt conforme, puis les parties horizontales de la couche isolante sont retirées, par exemple par gravure anisotrope verticale, de façon à conserver uniquement les portions de la couche isolante situées sur les parois latérales des tranchées, ces portions formant les espaceurs 131.

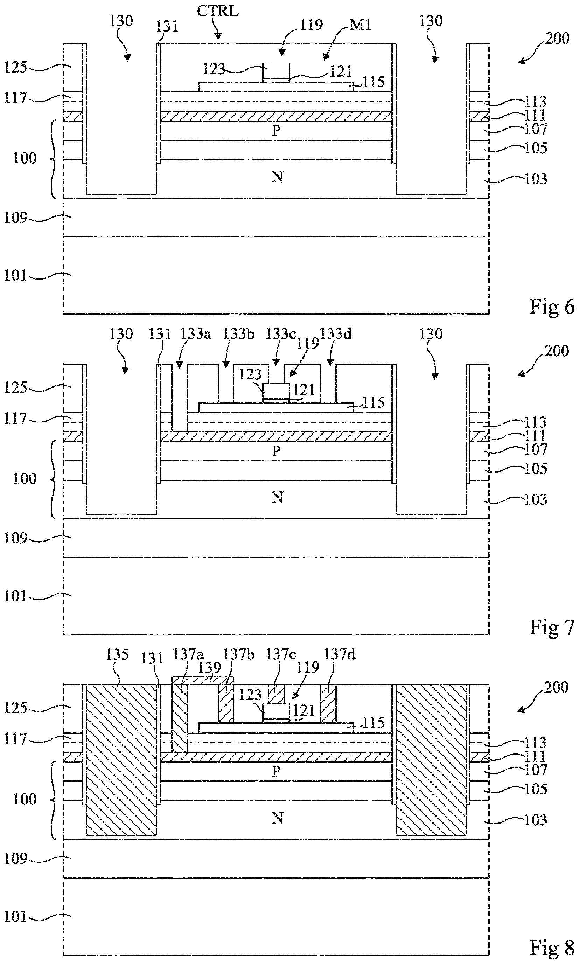

La figure 6 illustre une étape de prolongement des tranchées 130 dans la couche semiconductrice inférieure 103 de l'empilement de LED. Dans l'exemple représenté, la gravure est interrompue avant d'atteindre la face inférieure de la couche 103, c'est-à-dire que les tranchées 130 ne traversent pas entièrement la couche 103. A titre de variante, les tranchées 130 peuvent traverser entièrement la couche 103. Lors de cette étape, les flancs de la couche conductrice de contact d'anode 111 et des couches 107 et 105 sont protégés de la gravure par les espaceurs 131.

La figure 7 illustre une étape de formation, dans chaque pixel du dispositif, d'ouvertures de reprise de contact s'étendant verticalement depuis la face supérieure de la couche diélectrique 125 en direction de la face inférieure du substrat, et débouchant sur des régions de contact de source, de grille et de drain des transistors MOS et sur la couche conductrice de contact d'anode 111 du pixel. Dans l'exemple de la figure 7, on a représenté plus particulièrement, dans chaque pixel, une ouverture 133a débouchant sur la face supérieure de la couche de contact d'anode 111 du pixel, une ouverture 133b débouchant sur la face supérieure de la couche semiconductrice 115, sur une première région de conduction (source ou drain) d'un transistor MOS du pixel, une ouverture 133c débouchant sur la face supérieure de la couche conductrice de grille 123 d'un transistor MOS du pixel, et une ouverture 133d débouchant sur la face supérieure de la couche semiconductrice 115, sur une deuxième région de conduction (drain ou source) d'un transistor MOS du pixel.

Les ouvertures 133a, 133b, 133c, 133d peuvent être formées lors d'une même étape de photolithographie et gravure. Les modes de réalisation décrits ne se limitent toutefois pas à ce cas particulier. On notera que dans cet exemple, la couche semiconductrice 115 a préalablement été retirée, lors de l'étape de la figure 3, dans les zones de formation des ouvertures 133a. La gravure des ouvertures 133a ne traverse donc pas la couche semiconductrice 115. Les modes de réalisation décrits ne se limitent toutefois pas à ce cas particulier. Par ailleurs, bien que cela n'apparaisse pas sur les figures, les faces supérieures des zones de reprise de contact de source, de drain, et éventuellement de grille (dans le cas où les grilles sont en silicium polycristallin) des transistors peuvent avoir été préalablement siliciurées lors des étapes de fabrication de la figure 3, ce qui permet de faciliter l'arrêt de la gravure des ouvertures 133b, 133c et 133d, et de réduire les résistances d'accès aux régions de source, de drain, et, le cas échéant, de grille des transistors.

La figure 8 illustre une étape de remplissage des tranchées 130 par du métal, par exemple du cuivre, de façon à former une métallisation de contact de cathode 135 commune à toutes les LED du dispositif d'affichage. Dans cet exemple, les tranchées sont entièrement comblées par la métallisation 135. La métallisation 135 est en contact avec la couche 103 au fond et sur une partie inférieure des parois latérales des tranchées 130. La métallisation 135 est en revanche isolée des couches 105, 107 et 111 par les espaceurs 131.

La figure 8 illustre en outre une étape de remplissage des ouvertures 133a, 133b, 133c et 133d par du métal, par exemple du tungstène, de façon à former :
- dans chaque ouverture 133a, une métallisation de contact d'anode 137a spécifique à la LED sous-jacente,
- dans chaque ouverture 133b, une métallisation de contact de source ou de drain 137b spécifique au transistor sous-jacent ;
- dans chaque ouverture 133c, une métallisation de contact de grille 137c spécifique au transistor sous-jacent ; et
- dans chaque ouverture 133d, une métallisation de contact de drain ou de source 137d spécifique au transistor sous-jacent.

Les métallisations 137a, 137b, 137c, 137d peuvent être formées simultanément. Les modes de réalisation décrits ne se limitent toutefois pas à ce cas particulier. Les métallisations 137a, 137b, 137c, 137d peuvent être formées avant, en même temps que, ou après la métallisation 135. On notera que les modes de réalisation décrits ne se limitent pas à l'exemple représenté dans lequel la face supérieure de la métallisation 135 et les faces supérieures des métallisations 137a, 137b, 137c, 137d sont dans un même plan. A titre de variante, la métallisation 135 et les métallisations 137a, 137b, 137c, 137d peuvent avoir des hauteurs différentes.

La figure 8 illustre en outre une étape optionnelle de formation, dans chaque pixel, sur la face supérieure de la couche diélectrique 125, d'un élément conducteur de connexion 139, par exemple une piste métallique, connectant la métallisation de contact d'anode 137a du pixel à une métallisation de contact de source ou de drain 137b d'un transistor MOS de la cellule élémentaire de contrôle du pixel. L'élément de connexion 139 est par exemple une piste de cuivre disposée sur la face supérieure de l'assemblage, en contact, par sa face inférieure, d'une part avec la face supérieure de la métallisation 137a et d'autre part avec la face supérieure de la métallisation 137b.

D'autres pistes conductrices d'interconnexion (non représentées) peuvent être prévues pour, dans chaque pixel, connecter une ou plusieurs métallisations de contact du pixel à un circuit périphérique ou externe de commande du dispositif.

Le dispositif d'affichage ainsi réalisé est destiné à émettre de la lumière par sa face inférieure. A titre d'exemple, le substrat 101 est un substrat transparent, par exemple en saphir, ce qui permet de ne pas bloquer le passage de la lumière. On notera que pour augmenter sa transparence, le substrat 101 peut être aminci, voire retiré. Une poignée de support, par exemple sous la forme d'un substrat de silicium, peut éventuellement être solidarisée à la face supérieure de l'assemblage avant l'amincissement ou le retrait du substrat 101, pour assurer la tenue mécanique de l'ensemble.

Par rapport au procédé décrit dans la demande de brevet français FR3065322 susmentionnée, un avantage est que le report de la couche semiconductrice 115 sur la face supérieure de l'empilement actif de LED est simplifié par le fait que l'empilement actif de LED n'a pas encore été structuré au moment du report. Il est en particulier possible de réaliser le report avec une couche diélectrique d'interface (empilement des couches 113 et 117) d'épaisseur très faible, par exemple inférieure à 50 nm.

De plus, comme indiqué ci-dessus, par rapport aux demandes de brevet FR3065322 et FR1873315 susmentionnés, un avantage du procédé des figures 1 à 8 est que le budget thermique pour la réalisation du circuit de contrôle n'est pas limité par la présence de l'empilement actif de LED.

En outre, par rapport aux procédés décrits dans les demandes de brevet WO2017194845 et FR3073669 susmentionnées, un avantage du procédé décrit ci-dessus résulte du fait que les tranchées 130 de délimitation des LED sont formées à partir de la face supérieure de l'empilement de LED, c'est-à-dire la face de l'empilement de LED tournée vers le circuit de contrôle, ou, dit autrement, à partir de la face de l'empilement de LED opposée au substrat de support 101. Ceci permet de faciliter la reprise d'un contact électrique de bonne qualité sur la couche 103, sans court-circuiter les couches 105 et 107. On notera en particulier que dans le procédé décrit dans la demande de brevet WO2017194845, le contact est pris par la face de la couche 103 opposée au circuit de contrôle, ce qui réduit la surface d'éclairement de la LED. Le procédé décrit dans la demande de brevet FR3073669 comprend quant à lui une étape délicate de retrait partiel d'un espaceur préalablement formé dans la tranchée de délimitation de chaque LED.

On notera en outre que dans un empilement actif de LED du type décrit ci-dessus, la qualité cristalline de la partie supérieure (dans l'orientation de la figure 8) de la couche 103 est généralement meilleure que celle de la partie inférieure de la couche 103. Il en résulte que, dans le procédé décrit ci-dessus, l'attaque de la couche 103 lors de la réalisation des tranchées 130 est plus aisée que l'attaque de cette même couche dans les procédés décrits dans les demandes de brevet WO2017194845 et FR3073669 susmentionnées.

Bien que l'on ait décrit ci-dessus un exemple de réalisation dans lequel le circuit électronique de contrôle des LED est réalisé dans un unique niveau semiconducteur, correspondant à la couche semiconductrice 115, les modes de réalisation décrits ne se limitent pas à ce cas particulier. A titre de variante, un deuxième niveau semiconducteur peut être prévu au-dessus de la couche diélectrique 125, dans lequel sont réalisés d'autres éléments du circuit de contrôle des LED. Dans ce cas, les transistors à plus haute tension d'alimentation du circuit de contrôle sont de préférence réalisés dans le premier niveau semiconducteur (i.e. au plus proche des LED), les transistors à plus basse tension d'alimentation pouvant être situés dans le deuxième niveau semiconducteur. Le deuxième niveau semiconducteur peut être réalisé en technologie dite 3D séquentielle, c'est-à-dire par dépôt ou report d'une couche semiconductrice additionnelle sur la face supérieure de la couche diélectrique 125, puis réalisation de transistors MOS dans et sur la couche semiconductrice additionnelle. A titre de variante, le deuxième niveau semiconducteur peut être réalisé en technologie dite 3D parallèle, c'est-à-dire réalisé séparément du dispositif de la figure 8, puis hybridé avec la face supérieure du dispositif de la figure 8. Un plan de masse conducteur peut éventuellement être prévu entre les premier et deuxième niveaux semiconducteurs.

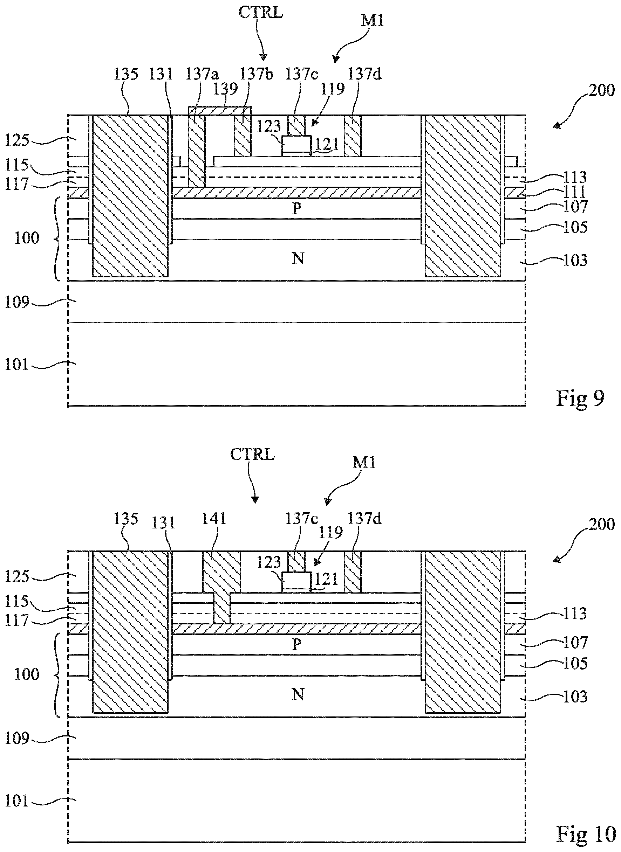

La figure 9 est une vue en coupe illustrant de façon schématique une première variante de réalisation du procédé des figures 1 à 8.

La variante de la figure 9 diffère du procédé des figures 1 à 8 principalement en ce que, dans cette variante, le motif d'isolation des transistors MOS formés dans et sur la couche semiconductrice 115 et le motif d'isolation des LED sont auto-alignés. Autrement dit, dans la variante de la figure 9, il n'est pas prévu de délimiter des caissons semiconducteurs dans la couche 115 préalablement au report du circuit 200 sur l'empilement actif de LED et à la formation des tranchées 130, comme décrit précédemment en relation avec la figure 3.

Ainsi, dans la variante de la figure 9, lors de l'étape de gravure localisée de la couche semiconductrice 115 (figure 3), la couche 115 est retirée uniquement dans les zones de formation ultérieure des ouvertures 133a.

Dans la variante de la figure 9, dans chaque pixel, tous les transistors MOS du pixel formés dans et sur la couche semiconductrice 115 partagent une même zone active. La dimension des pixels peut ainsi être réduite. A titre d'exemple, dans la variante de la figure 9, dans chaque pixel, un unique transistor MOS à haute tension d'alimentation, par exemple de tension d'alimentation comprise entre 3 et 15 volts, est formé dans et sur la portion de couche semiconductrice 115 du pixel, ce transistor occupant sensiblement la même surface que la LED du pixel. Chaque pixel peut en outre comprendre des transistors à plus basse tension d'alimentation, par exemple de tension d'alimentation comprise entre 0,5 et 5 volts, formés dans un deuxième niveau semiconducteur (non représenté), au-dessus de la couche semiconductrice 115.

La figure 10 est une vue en coupe illustrant de façon schématique une deuxième variante de réalisation du procédé des figures 1 à 8.

La variante de la figure 10 diffère du procédé des figures 1 à 8 principalement en ce que, dans cette variante, dans chaque pixel, au lieu de prévoir une métallisation de contact d'anode 137a et une métallisation de contact de source ou drain 137b connectées par une piste conductrice 139, on prévoit une unique métallisation de contact partagée 141 traversant la couche semiconductrice 115 et connectant la région de source ou drain du transistor MOS à la couche conductrice de contact d'anode 111 du pixel.

Dans cette variante, la couche semiconductrice 115 n'est pas retirée dans la zone de formation de la métallisation de contact partagée 141 à l'étape de la figure 3.

La formation de la métallisation de contact partagée 141 comprend par exemple les étapes successives suivantes (non détaillées sur la figure 10) :
- former, à partir de la face supérieure de la couche diélectrique 125, une première ouverture s'étendant verticalement jusqu'à la face supérieure de la couche semiconductrice 115 (de préférence sur une région préalablement siliciurée de la face supérieure de la couche 115) ;
- former sur les parois latérales de la première ouverture des espaceurs en un matériau sacrificiel ;
- prolonger la première ouverture par une deuxième ouverture de dimension latérale réduite (du fait de la présence des espaceurs sacrificiels) traversant la couche semiconductrice 115 et s'étendant verticalement jusqu'à la face supérieure de la couche de contact d'anode 111 ;
- retirer les espaceurs sacrificiels ;
- remplir les première et deuxième ouvertures par du métal, par exemple du tungstène, pour former la métallisation 141.

La métallisation 141 ainsi réalisée est en contact avec la face supérieure de la couche semiconductrice 115 au fond de la première ouverture, et avec la face supérieure de la couche de contact d'anode 111 au fond de la deuxième ouverture.

A titre de variante (non représentée), l'ouverture dans laquelle est disposée la métallisation 141 peut être formée en une seule étape, auquel cas la métallisation 141 est en contact avec la couche semiconductrice 115 uniquement par les flancs de la couche 115.

La variante de la figure 10 permet de gagner en densité d'intégration des pixels.

On notera que les variantes des figures 9 et 10 peuvent être combinées, comme l'illustre la figure 10. Dans ce cas, l'étape de gravure localisée de la couche semiconductrice 115 de la figure 3 peut être omise. A titre de variante, la métallisation de contact partagée 141 décrite en relation avec la figure 10 peut être prévue dans un dispositif du type représenté en figure 8, c'est-à-dire dans lequel le motif d'isolation des transistors MOS formés dans et sur la couche semiconductrice 115 et le motif d'isolation des LED ne sont pas auto-alignés.

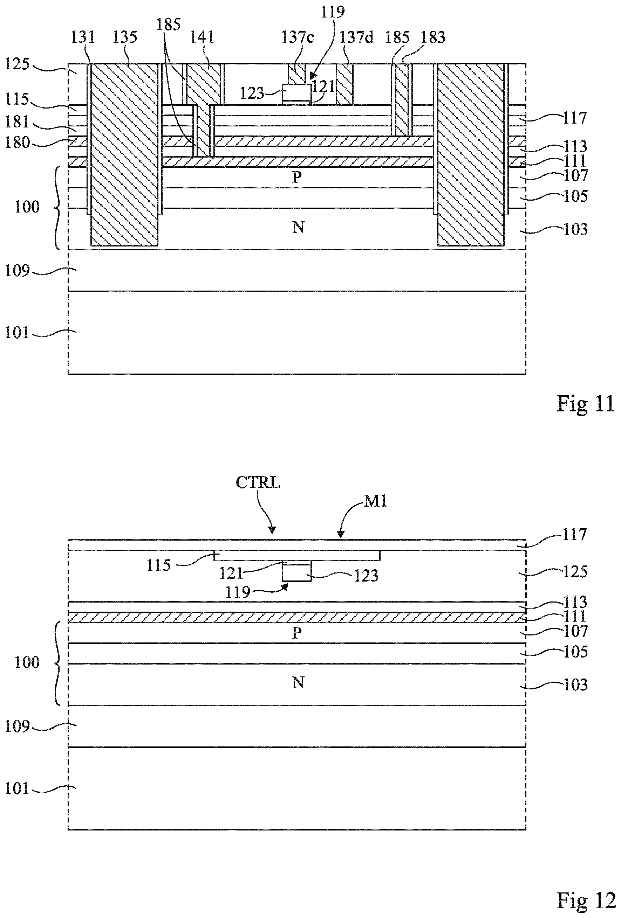

La figure 11 est une vue en coupe illustrant de façon schématique une troisième variante de réalisation du procédé des figures 1 à 8.

La variante de la figure 11 diffère de ce qui a été décrit précédemment principalement en ce que le dispositif comprend en outre, dans chaque pixel, entre la couche conductrice de contact d'anode 111 et la couche semiconductrice 115, un plan de masse 180 formé par une couche d'un matériau conducteur ou semiconducteur, par exemple une couche de silicium polycristallin dopé. En fonctionnement, le plan de masse 180 est maintenu à un potentiel de référence du dispositif, par exemple la masse, et permet de découpler la LED de la cellule élémentaire de contrôle du pixel, et notamment d'éviter que les niveaux de tension relativement élevés appliqués sur la couche de contact d'anode de la LED n'induisent une modification du comportement du ou des transistors de la cellule élémentaire de contrôle du pixel.

Dans l'exemple représenté, le plan de masse 180 est disposé entre la couche diélectrique 113 et la couche semiconductrice diélectrique 117, une couche diélectrique additionnelle 181, par exemple en oxyde de silicium, faisant interface entre le plan de masse 180 et la couche diélectrique 117.

A titre d'exemple, le plan de masse 180 et la couche diélectrique 181 peuvent être déposés successivement sur la face supérieure de la couche 113 à l'issue des étapes des figures 1 et 2. A titre d'exemple, le plan de masse 180 et la couche diélectrique 181 peuvent chacun s'étendre de façon continue sur toute la surface de la couche 113.

La suite du procédé est par exemple identique ou similaire à ce qui a été décrit précédemment, à ceci près que :
- lors du report du circuit 200 sur l'empilement actif de LED, la fixation du circuit 200 sur l'empilement actif de LED est réalisée par collage direct de la couche diélectrique 117 sur la couche diélectrique 181 ;
- la métallisation de reprise de contact sur la couche de contact d'anode 111 de la LED traverse le plan de masse 180 et doit donc être isolée du plan de masse 180 ; et
- chaque pixel comprend une métallisation de reprise de contact additionnelle 183 pour la polarisation du plan de masse 180.

Dans l'exemple représenté, la métallisation de reprise de contact additionnelle 183 traverse la couche semiconductrice 115 et est isolée de cette dernière par une couche isolante latérale 185, par exemple en oxyde de silicium.

De plus, dans cet exemple, la métallisation 141 de reprise de contact d'anode est une métallisation partagée avec la couche semiconductrice 115, similaire à ce qui a été décrit dans l'exemple de la figure 10. Toutefois, dans la variante de la figure 11, la métallisation 141 traverse le plan de masse 180 et est isolée de ce dernier par une couche isolante latérale 187, par exemple en oxyde de silicium.

La variante de la figure 11 pourra bien entendu être combinée avec toutes les variantes décrites précédemment.

La figure 12 est une vue en coupe illustrant de façon schématique une quatrième variante de réalisation du procédé des figures 1 à 8.

La variante de la figure 12 diffère de ce qui a été décrit précédemment en ce que, dans cette variante, le circuit de contrôle 200 est reporté sur l'empilement actif de LED face avant tournée vers la face avant de l'empilement actif de LED, et non plus face arrière tournée vers la face avant de l'empilement actif de LED. Par face avant du circuit 200, on entend ici sa face située côté empilement de grilles 119, c'est-à-dire sa face supérieure dans l'orientation de la figure 3. Par face avant de l'empilement actif de LED, on entend ici sa face opposée au substrat 101, c'est-à-dire sa face supérieure dans l'orientation de la figure 2.

La figure 12 illustre plus particulièrement l'étape de report du circuit 200 sur l'empilement actif de LED. Dans cet exemple, le circuit 200 est rapporté sur la face supérieure de la couche diélectrique 113, de façon à mettre en contact la face de la couche diélectrique 125 opposée au substrat 118 avec la face supérieure de la couche diélectrique 113. On réalise ainsi un collage direct ou collage moléculaire de la couche 125 sur la couche 113, permettant de solidariser le circuit 200 à la couche 113. Le substrat 118 (ou une partie du substrat 118) peut ensuite être retiré de façon à libérer l'accès à la face supérieure de la couche 117.

Les étapes ultérieures du procédé sont par exemple identiques ou similaires à ce qui a été décrit précédemment en relation avec les figures 5 à 8, à ceci près que les contacts sur les régions de source, de drain et de grille des transistors (figures 7 et 8) sont cette fois réalisés du côté de la face arrière du circuit 200. On notera en particulier que dans cette variante, les contacts sur les grilles des transistors seront déportés de façon à ne pas traverser la région de canal des transistors. Des étapes non détaillées de siliciuration de la face arrière de la couche semiconductrice et/ou de la grille conductrice 123 peuvent être prévues au niveau des zones de reprise de contact.

La variante de la figure 12 peut être combinée avec toutes les variantes décrites précédemment.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les modes de réalisation décrits ne se limitent pas aux exemples de matériaux décrits ci-dessus, ni aux exemples de dimensions mentionnées ci-dessus.

De plus, les types de conductivité des couches semiconductrices 103 et 107 de l'empilement de LED 100 peuvent être inversés.

Par ailleurs, bien que l'on ait décrit uniquement des exemples de réalisation de dispositifs d'affichage à base de LED, les modes de réalisation décrits peuvent être adaptés à la fabrication d'un capteur comportant une pluralité de photodiodes, par exemple au nitrure de gallium, adressables individuellement pour acquérir une image.

Plus généralement, les modes de réalisation décrits peuvent être adaptés à la fabrication de tout dispositif d'affichage ou capteur photosensible à base de diodes semiconductrices, y compris à base de matériaux semiconducteurs autres que le nitrure de gallium, par exemple des diodes à base d'autres matériaux semi-conducteurs III-V ou des diodes à base de silicium.

## Revendications

1. Procédé de fabrication d'un dispositif optoélectronique, comportant les étapes suivantes :
a) former un empilement actif de diode (100) comportant une première couche semiconductrice (103) dopée d'un premier type de conductivité et une deuxième couche semiconductrice (107) dopée du deuxième type de conductivité, revêtant la face supérieure de la première couche ;
b) former un circuit intégré de contrôle (200) comprenant une pluralité de cellules élémentaires de contrôle (CTRL) comprenant chacune au moins un transistor MOS (M1) ;
c) après les étapes a) et b), rapporter le circuit intégré de contrôle (200) sur la face supérieure de l'empilement actif de diode (100) ; et
d) après l'étape c), former, depuis la face du circuit intégré de contrôle (200) opposée à l'empilement actif de diode (100), des tranchées (130) s'étendant verticalement à travers le circuit intégré de contrôle (200) et débouchant dans la première couche (103) ou sur la face supérieure de la première couche (103) **caractérisé en ce que** les tranchées délimitent une pluralité de pixels comprenant chacun une diode et une cellule élémentaire de contrôle (CTRL).

2. Procédé selon la revendication 1, dans lequel, en vue de dessus, les tranchées (130) forment une grille continue séparant les uns des autres les pixels du dispositif.

3. Procédé selon la revendication 2, comprenant en outre une étape de remplissage des tranchées (130) par du métal de façon à former une métallisation (135) de contact avec la première couche semiconductrice (103), commune à tous les pixels du dispositif.

4. Procédé selon la revendication 3, dans lequel, avant le remplissage des tranchées (130) par du métal, une couche d'isolation (131) est déposée sur les parois latérales des tranchées.

5. Procédé selon l'une quelconque des revendications 1 à 4, dans lequel le circuit intégré de contrôle (200) comprend une troisième couche semiconductrice (115) dans et sur laquelle sont formés les transistors MOS (M1) des cellules élémentaires de contrôle.

6. Procédé selon la revendication 5, dans lequel, à l'étape b), la troisième couche semiconductrice (115) est retirée dans les zones de formation des tranchées (130).

7. Procédé selon la revendication 5, dans lequel la troisième couche semiconductrice (115) n'est pas retirée dans les zones de formation des tranchées (130) avant l'étape d).

8. Procédé selon l'une quelconque des revendications 5 à 7, comprenant en outre, après l'étape c), une étape de formation, dans chaque pixel, d'une métallisation de contact (137a ; 141) avec la deuxième couche semiconductrice (107), et d'une métallisation de contact (137b ; 141) avec la troisième couche semiconductrice (115).

9. Procédé selon la revendication 8, dans lequel la métallisation de contact (137a) avec la deuxième couche semiconductrice (107) et la métallisation de contact (137b) avec la troisième couche semiconductrice (115) sont des métallisations distinctes, connectées l'une à l'autre par une piste conductrice (139) en contact avec les faces supérieures desdites métallisations.

10. Procédé selon la revendication 8, dans lequel la métallisation de contact (141) avec la deuxième couche semiconductrice (107) et la métallisation de contact (141) avec la troisième couche conductrice (115) sont confondues et sont disposées dans une même ouverture traversant la troisième couche semiconductrice (115).

11. Procédé selon l'une quelconque des revendications 5 à 10, comprenant en outre, avant l'étape c), une étape de dépôt d'une couche métallique (111) sur et en contact avec la face de la deuxième couche semiconductrice (107) opposée à la première couche semiconductrice (103).

12. Procédé selon l'une quelconque des revendications 5 à 11, comprenant en outre, avant l'étape c), la formation d'un plan de masse (180) conducteur ou semiconducteur entre la deuxième couche semiconductrice (107) et la troisième couche semiconductrice (115), le plan de masse (180) étant isolé des deuxième (107) et troisième (115) couches semiconductrices.

13. Procédé selon la revendication 12, comprenant une étape de formation, dans chaque pixel, d'une métallisation de contact (183) avec le plan de masse (180), ladite métallisation étant disposée dans une ouverture traversant la troisième couche semiconductrice (115).

14. Procédé selon l'une quelconque des revendications 5 à 13, dans lequel, à l'étape c), le circuit intégré de contrôle (200) est rapporté de façon que les grilles des transistors MOS soient orientées à l'opposé de la face supérieure de l'empilement actif de diode.

15. Procédé selon l'une quelconque des revendications 5 à 13, dans lequel, à l'étape c), le circuit intégré de contrôle (200) est rapporté de façon que les grilles des transistors MOS soient orientées vers l'empilement actif de diode.

16. Procédé selon l'une quelconque des revendications 5 à 15, dans lequel les première (103) et deuxième (107) couches semiconductrices sont des couches à base de matériaux semiconducteurs III-V, et la troisième couche semiconductrice (115) est en silicium.

## Patentansprüche

1. Ein Verfahren zur Herstellung einer optoelektronischen Vorrichtung, das die folgenden Schritte aufweist:
a) Bilden eines aktiven Diodenstapels (100), der eine erste dotierte Halbleiterschicht (103) eines ersten Leitfähigkeitstyps und eine zweite dotierte Halbleiterschicht (107) eines zweiten Leitfähigkeitstyps aufweist, wobei die obere Fläche der ersten Schicht beschichtet wird;
b) Bilden einer integrierten Steuerschaltung (200), die eine Vielzahl von elementaren Steuerzellen (CTRL) aufweist, die jeweils mindestens einen MOS-Transistor (M1) aufweisen;
c) nach den Schritten a) und b), Übertragen der integrierten Steuerschaltung (200) auf die obere Oberfläche des aktiven Diodenstapels (100); und
d) nach Schritt c) Bilden von Gräben (130), von der dem aktiven Diodenstapel (100) gegenüberliegenden Oberfläche der integrierten Steuerschaltung (200) aus, die sich vertikal durch die integrierte Steuerschaltung (200) erstrecken und in die erste Schicht (103) oder auf die obere Oberfläche der ersten Schicht (103) münden, gekennzeichent dadurch, dass die Gräben eine Vielzahl von Pixeln begrenzen, die jeweils eine Diode und eine elementare Steuerzelle (CTRL) aufweisen.

2. Das Verfahren nach Anspruch 1, wobei die Gräben (130) in der Draufsicht ein durchgehendes Gate bilden, das die Pixel der Vorrichtung voneinander trennt.

3. Das Verfahren nach Anspruch 2, das ferner einen Schritt des Füllens der Gräben (130) mit Metall aufweist, um eine Metallisierung (135) des Kontakts mit der ersten Halbleiterschicht (103) zu bilden, die allen Pixeln der Vorrichtung gemeinsam ist.

4. Das Verfahren nach Anspruch 3, wobei vor dem Füllen der Gräben (130) mit Metall eine Isolierschicht (131) auf den Seitenwänden der Gräben aufgebracht wird.

5. Das Verfahren nach Anspruch 1, bei dem die integrierte Steuerschaltung (200) eine dritte Halbleiterschicht (115) aufweist, in und auf der die MOS-Transistoren (M1) der elementaren Steuerzellen ausgebildet sind.

6. Das Verfahren nach Anspruch 5, wobei in Schritt b) die dritte Halbleiterschicht (115) von den grabenbildenden Bereichen (130) entfernt wird.

7. Das Verfahren nach Anspruch 5, wobei die dritte Halbleiterschicht (115) nicht vor Schritt d) aus den grabenbildenden Bereichen (130) entfernt wird.

8. Das Verfahren nach Anspruch 5, das ferner nach Schritt c) einen Schritt zum Bilden, in jedem Pixel, einer Metallisierung (137a; 141) des Kontakts mit der zweiten Halbleiterschicht (107) und einer Metallisierung des Kontakts (137b; 141) mit der dritten Halbleiterschicht (115) aufweist.

9. Das Verfahren nach Anspruch 8, wobei die Metallisierung (137a) des Kontakts mit der zweiten Halbleiterschicht (107) und die Metallisierung (137b) des Kontakts mit der dritten Halbleiterschicht (115) getrennte Metallisierungen sind, die durch eine Leiterbahn (139) in Kontakt mit den oberen Oberflächen der Metallisierungen miteinander verbunden sind.

10. Das Verfahren nach Anspruch 8, wobei die Metallisierung (141) des Kontakts mit der zweiten Halbleiterschicht (107) und die Metallisierung (141) des Kontakts mit der dritten leitenden Schicht (115) miteinander verbunden sind und in einer gleichen Öffnung angeordnet sind, die die dritte Halbleiterschicht (115) kreuzt.

11. Das Verfahren nach Anspruch 5, das ferner vor Schritt c) einen Schritt zum Abscheiden einer Metallschicht (111) auf und in Kontakt mit der Oberfläche der zweiten Halbleiterschicht (107) gegenüber der ersten Halbleiterschicht (103) aufweist.

12. Das Verfahren nach Anspruch 5, das ferner vor Schritt c) das Bilden einer leitenden oder Halbleiter-Grundplatte (180) zwischen der zweiten Halbleiterschicht (107) und der dritten Halbleiterschicht (115) aufweist, wobei die Grundplatte (180) von der zweiten (107) und dritten (115) Halbleiterschicht isoliert ist.

13. Das Verfahren nach Anspruch 12, das einen Schritt zum Bilden, in jedem Pixel, einer Metallisierung (183) in Kontakt mit der Grundplatte (180) aufweist, wobei die Metallisierung in einer Öffnung angeordnet ist, die die dritte Halbleiterschicht (115) kreuzt.

14. Das Verfahren nach Anspruch 5, bei dem in Schritt c) die integrierte Steuerschaltung (200) so übertragen wird, dass die Gates der MOS-Transistoren entgegengesetzt zur oberen Oberfläche des aktiven Diodenstapels ausgerichtet sind.

15. Das Verfahren nach Anspruch 5, wobei in Schritt c) die integrierte Steuerschaltung (200) so übertragen wird, dass die Gates der MOS-Transistoren in Richtung des aktiven Diodenstapels ausgerichtet sind.

16. Das Verfahren nach Anspruch 5, wobei die erste (103) und zweite (107) Halbleiterschicht Schichten auf Basis von III-V-Halbleitermaterialien sind und die dritte Halbleiterschicht (115) aus Silizium besteht.

## Claims

1. Optoelectronic device manufacturing method, comprising the steps of:
a) forming an active diode stack (100) comprising a first doped semiconductor layer (103) of a first conductivity type and a second doped semiconductor layer (107) of the second conductivity type, coating the upper surface of the first layer;
b) forming an integrated control circuit (200) comprising a plurality of elementary control cells (CTRL), each comprising at least one MOS transistor (M1);
c) after steps a) and b), transferring the integrated control circuit (200) onto the upper surface of the active diode stack (100); and
d) after step c), forming, from the surface of the integrated control circuit (200) opposite to the active diode stack (100), trenches (130) extending vertically through the integrated control circuit (200) and emerging into the first layer (103) or onto the upper surface of the first layer (103), **characterized in that** the trenches delimit a plurality of pixels, each comprising a diode and an elementary control cell (CTRL).

2. Method according to claim 1, wherein, in top view, the trenches (130) form a continuous gate separating from one another the pixels of the device.

3. Method according to claim 2, further comprising a step of filling of the trenches (130) with metal to form a metallization (135) of contact with the first semiconductor layer (103), common to all the pixels of the device.

4. Method according to claim 3, wherein, before the filling of the trenches (130) with metal, an insulation layer (131) is deposited on the lateral walls of the trenches.

5. Method according to claim 1, wherein the integrated control circuit (200) comprises a third semiconductor layer (115) having the MOS transistors (M1) of the elementary control cells formed inside and in top of it.

6. Method according to claim 5, wherein, at step b), the third semiconductor layer (115) is removed from the trench-forming areas (130).

7. Method according to claim 5, wherein the third semiconductor layer (115) is not removed from the trench-forming areas (130) before step d).

8. Method according to claim 5, further comprising, after step c), a step of forming, in each pixel of a metallization (137a; 141) of contact with the second semiconductor layer (107), and of a metallization of contact (137b; 141) with the third semiconductor layer (115).

9. Method according to claim 8, wherein the metallization (137a) of contact with the second semiconductor layer (107) and the metallization (137b) of contact with the third semiconductor layer (115) are separate metallizations, connected to each other by a conductive track (139) in contact with the upper surfaces of said metallizations.

10. Method according to claim 8, wherein the metallization (141) of contact with the second semiconductor layer (107) and the metallization (141) of contact with the third conductive layer (115) are confounded and are arranged in a same opening crossing the third semiconductor layer (115).

11. Method according to claim 5, further comprising, before step c), a step of deposition of a metal layer (111) on top of and in contact with the surface of the second semiconductor layer (107) opposite to the first semiconductor layer (103).

12. Method according to claim 5, further comprising, before step c), the forming of a conductive or semiconductor ground plane (180) between the second semiconductor layer (107) and the third semiconductor layer (115), the ground plane (180) being insulated from the second (107) and third (115) semiconductor layers.

13. Method according to claim 12, comprising a step of forming, in each pixel, of a metallization (183) of contact with the ground plane (180), said metallization being arranged in an opening crossing the third semiconductor layer (115).

14. Method according to claim 5, wherein, at step c), the integrated control circuit (200) is transferred so that the gates of the MOS transistors are oriented opposite to the upper surface of the active diode stack.

15. Method according to claim 5, wherein, at step c), the integrated control circuit (200) is transferred so that the gates of the MOS transistors are oriented towards the active diode stack.

16. Method according to claim 5, wherein the first (103) and second (107) semiconductor layers are layers based on III-V semiconductor materials, and the third semiconductor layer (115) is made of silicon.
